# FASCICULE DE BREVET EUROPEEN

(11) **EP 2 880 453 B1**
(45) Date de publication et mention de la délivrance du brevet: **09.11.2016**
(21) Numéro de dépôt: 13756608.9
(22) Date de dépôt: 26.07.2013
(51) Int. Cl.: G01R 15/18, H01F 38/30

(54) **DISPOSITIF DE MESURE DU COURANT CIRCULANT DANS UN CONDUCTEUR**
GERÄT ZUR MESSUNG EINES IN EINEM LEITER FLIESSENDEN STROMS
DEVICE FOR MEASURING CURRENT FLOWING IN A CONDUCTOR

(30) Priorité: 31.07.2012 FR 1257410
(43) Date de publication de la demande: 10.06.2015
(73) Titulaire: Hager-Electro SAS, 67210 Obernai (FR)
(72) Inventeur: STOCKER, Gilles, F-67880 Krautergersheim (FR); HAMM, Thomas, F-67120 Ergersheim (FR)
(74) Mandataire: Nuss, Laurent
(86) Numéro de dépôt international: PCT/FR2013/051813
(87) Numéro de publication internationale: WO 2014/020268

(56) Documents cités:
- EP-A1- 1 936 389
- DE-A1- 3 243 274
- DE-A1- 4 400 418
- DE-T2- 60 000 200
- FR-A1- 2 800 167
- GB-A- 260 603
- US-A1- 2002 017 976
- US-A1- 2004 183 520

## Description

L'invention se rapporte à un dispositif de mesure du courant circulant dans un conducteur. Elle s'applique en fait plus particulièrement à la mesure industrielle de courants alternatifs dans des gammes de produits ayant des fonctions de protection, du type disjoncteur électronique où ce dispositif de mesure du courant remplace les fonctions magnéto-thermiques classiques, et/ou des fonctions de comptage (mesure du courant, mesure de tension, ...), du type produits communicants.

Le principe de base des dispositifs de mesure de courant actuels, lorsqu'ils sont intégrés à des appareils du type disjoncteur, consiste à peu près invariablement à entourer la voie de courant, dite primaire, par un capteur.

Il peut s'agir d'un capteur à noyau ferromagnétique, du type transformateur de courant, ledit noyau entourant le conducteur dans lequel circule le courant primaire à mesurer de manière à concentrer et guider les flux magnétiques générés par ledit courant primaire et à susciter dans une bobine dite secondaire, entourant une portion du noyau, un courant dépendant dudit flux.

L'inconvénient d'un capteur du type transformateur de courant est la saturation possible de la matière ferromagnétique constituant le noyau, susceptible d'entrainer une distorsion du signal de sortie du capteur. En pratique, lors de la mesure de courants primaires importants, le signal de sortie perd sa linéarité, ce qui n'est évidemment pas admissible pour un capteur de mesure.

Il peut également s'agir d'un capteur sans noyau ferromagnétique, du type boucle de Rogowski. Cette boucle consiste en une bobine enroulée sur un noyau en matériau amagnétique qui entoure le conducteur primaire dans lequel circule le courant à mesurer. La tension fournie aux bornes de la bobine est alors directement proportionnelle à la dérivée de à l'intensité du courant électrique circulant dans le conducteur.

L'absence de noyau magnétique saturable permet une plus large dynamique de mesure. Cependant, la difficulté à fournir un signal propre en sortie et le fait que le niveau de signal, c'est-à-dire en pratique le rapport signal sur bruit, soit très faible en sortie constituent autant d'inconvénients à l'utilisation de ces bobines de Rogowski.

De plus, les bobines de Rogowski sont souvent difficiles à fabriquer puisqu'elles requièrent soit l'assemblage de plusieurs bobines de manière à ce qu'elles fassent le tour complet du conducteur primaire tout en essayant de maîtriser une continuité entre les bobines, comme cela est expliqué dans le brevet FR 2 870 350, soit une bobine torique présentant une confection complexe faisant le tour du conducteur.

DE 44 00 418 A1 concerne un transformateur de courant.

La présente invention se propose de supprimer ces inconvénients et de réaliser un dispositif de mesure de courant de construction simple et d'utilisation facile, ayant une bonne linéarité du signal en sortie même pour de forts courants, et proposant un niveau de signal élevé.

Pour satisfaire ces objectifs, et d'autres qui apparaîtront dans la suite de la description, le dispositif de mesure de courant selon l'invention comporte au moins une bobine, sans noyau ferromagnétique, placée au voisinage d'un conducteur parcouru par le courant à mesurer. L'invention se caractérise à titre principal en ce que ledit conducteur entoure au moins partiellement ladite bobine.

Cette configuration prend en fait l'exact contrepied de ce qui a toujours été réalisé. Ce n'est en effet plus la bobine qui fait le tour du conducteur primaire, mais le conducteur primaire qui fait le tour de la bobine. L'avantage majeur de cette invention réside dans l'amélioration sensible du rapport signal / bruit, qui est nettement supérieur à celui des bobines de Rogowski.

Ce dispositif de mesure ne comprend qu'une seule bobine disposée sur une carcasse isolante. Il n'est donc plus nécessaire d'assembler plusieurs bobines pour réaliser le capteur de mesure. L'avantage d'utiliser une bobine avec une carcasse isolante permet de plus et comme mentionné d'éviter tout risque de saturation. Par conséquent, cette absence de noyau ferromagnétique potentiellement saturable permet de conserver une linéarité du signal de sortie du capteur, quel que soit le courant à mesurer.

Avantageusement, la bobine comporte un nombre de spires de fil invariable par unité de longueur. Plus précisément, elle peut comporter un nombre de couches de spires de fil invariable par unité de longueur, le pas de l'enroulement des spires étant constant. Il s'agit donc d'une bobine standard, très simple de fabrication, nécessitant peu de matière première et donc économique.

Cette régularité de la densité linéaire des spires sur la bobine permet également d'éviter toute influence sur la propreté du signal en sortie, c'est-à-dire éviter toute distorsion de l'image du courant qui circule dans le conducteur primaire.

Selon l'invention, le conducteur est de préférence en forme de boucle entourant la bobine.

Il est alors par exemple constitué d'une tôle métallique comportant :
- une partie centrale se divisant en plusieurs bras de manière à réaliser une boucle entourant la bobine ;
- une première et une deuxième extrémités consistant en des bornes de raccordement.

Selon une première configuration possible, la partie centrale du conducteur peut être constituée d'une branche principale relié à l'une des extrémités et entourant au moins la moitié de la bobine, qui s'élargit et se divise en deux bras passant de part et d'autre de la branche principale et se rejoignant au niveau de l'autre extrémité.

A l'endroit auquel elle s'élargit, la plus grande largeur de la branche principale peut, dans une réalisation possible, correspondre sensiblement à la longueur de la bobine.

Alternativement, on peut concevoir des solutions dans lesquelles la bobine est moins longue que ladite largeur, dans lesquelles les bras s'enroulent par conséquent de part et d'autre de la bobine, envisagée axialement.

Suivant une possibilité configurationnelle additionnelle, les bras et la branche principale peuvent être coplanaires au niveau de la fermeture de la boucle. Il est à noter que les caractéristiques ci-dessus peuvent être combinées ou non, au gré de l'utilisateur, car elles sont indépendantes et relèvent de choix distincts de conception.

Alternativement encore, il est proposé une version dans laquelle lesdits deux bras ont une forme en S, un des arcs inversés du S fermant la boucle entourant la bobine et l'autre se terminant au niveau d'une borne de raccordement d'une extrémité.

Optionnellement, la partie centrale peut comporter une dérivation reliée auxdits bras ou à la branche principale et venant entourer la bobine de manière à réaliser une seconde boucle autour de la bobine. Plus le nombre de tour du conducteur primaire autour de la bobine est grand plus le niveau de signal en sortie de la bobine est grand, ce qui permet d'augmenter la précision de la mesure du courant.

Cette option de multiplier le nombre de tour du conducteur primaire peut être envisagée pour répondre à une segmentation de gamme d'appareils de protection en fonction de différents paramètres (encombrement, coût, niveau du signal à traiter, industrialisation).

L'inconvénient de la double boucle réside dans la surchauffe qu'elle provoque et qui n'est pas souhaitable pour l'ensemble du produit en général et particulièrement pour l'électronique dont la durée de vie risque de diminuer sensiblement.

De plus, la double boucle prend plus de place qu'une simple boucle et est plus coûteuse en matière première.

Dans le dispositif de mesure selon l'invention, il est donc nécessaire de trouver un équilibre entre les positions respectives du conducteur et de la bobine de manière à éviter tout échauffement excessif du produit en général en fonction du calibre du conducteur.

Pour répondre à des critères de montage du dispositif de l'invention dans certains appareils de protection, les extrémités formant bornes de raccordement sont de préférence orientées sensiblement parallèlement l'une à l'autre, de part et d'autre de la boucle selon la direction de la ligne protégée, et elles se montent en série dans ladite ligne dans un boîtier d'appareil de protection.

Pour augmenter le rendement du capteur ainsi constitué, le dispositif de mesure de courant peut au surplus comporter des moyens de guidage du flux magnétique généré par la bobine. Ils consistent en au moins un blindage en U entourant une portion de la boucle constituant la partie centrale du conducteur. Ce blindage, en matériau ferromagnétique, concentre ainsi les flux magnétiques émanant de la bobine autour du conducteur primaire uniquement, et non pas au-delà. L'avantage de la structure en U est qu'elle ne sature pas aussi vite qu'un circuit fermé, magnétiquement parlant, et ne provoque donc aucune déformation du signal même en cas de courant important dans le conducteur.

Selon une possibilité, qui correspond notamment à certaines configurations mentionnées auparavant, la base du blindage peut par exemple être disposée parallèlement à et entre d'une part une portion de la partie centrale du conducteur entourant la bobine et d'autre part une extrémité du conducteur située en regard, les deux branches du U étant dirigées respectivement en direction des deux extrémités de la bobine.

De manière opportune, le blindage en U peut être associé à une palette mobile de manière à former un circuit magnétique autour de la boucle du conducteur, le déplacement de ladite palette en fonction des conditions du circuit magnétique pouvant notamment être mis à profit par un déclencheur lié à la palette et provoquant le déclenchement d'une serrure lorsqu'une surcharge traverse le conducteur. De cette manière, le blindage est utilisé non seulement pour canaliser les flux magnétiques, mais également pour former un circuit magnétique susceptible d'apporter à peu de frais une fonction supplémentaire au dispositif de l'invention. L'actionnement de la palette mobile et du système déclencheur éventuellement placé en aval permet d'ouvrir des contacts électriques tributaires de la serrure en question.

Ce type de déclenchement intervient notamment lorsque l'électronique n'a pas le temps de gérer le déclenchement du disjoncteur, notamment lorsque le courant dépasse 40 x In (courant nominal). Dans ce cas, les moyens électroniques s'avèrent trop lents pour opérer un déclenchement.

L'association du dispositif de mesure avec un déclencheur n'est cependant possible que lorsque les courants circulant dans le circuit magnétique ne s'annulent pas, d'où l'intérêt d'avoir une configuration où le conducteur repasse à proximité de la bobine, entre les bras latéraux, ou plus généralement passe un nombre impair de fois dans le circuit magnétique.

Par ailleurs, le dispositif de mesure de l'invention peut être associé à un transformateur de courant à noyau magnétique disposé autour d'un tronçon du conducteur et servant à alimenter une électronique de commande via un bobinage secondaire. La bobine du dispositif de mesure de l'invention n'étant pas assez puissante pour délivrer un signal de mesure et alimenter simultanément une électronique de commande, il est nécessaire d'ajouter un tel transformateur de courant avec sa propre bobine audit dispositif de mesure.

Ce transformateur peut être localisé à différents emplacements, en fonction de la forme du conducteur et de l'agencement entre le conducteur et la bobine. Par exemple, il peut être placé en amont de la bobine, en référence au sens du courant, au voisinage d'une borne de raccordement du conducteur. Dans ce cas, le blindage dont il a été fait état auparavant permet en outre d'éviter que ledit transformateur n'« aspire» les flux magnétiques en dehors de la zone bouclée par le conducteur. La présence d'un blindage tel que décrit précédemment devient alors nécessaire pour guider les flux uniquement autour de la bobine.

Selon une possibilité améliorant la compacité de l'ensemble, le noyau magnétique dudit transformateur peut être disposé autour de la partie centrale en boucle du conducteur, autour de la bobine. Dans ce cas, il n'y a plus d'« aspiration » parasite des flux magnétiques hors de la zone bouclée par le conducteur, mais au contraire canalisation voire amplification des flux magnétiques qui sont guidés à l'instar de la situation précédente avec le blindage. Par conséquent, lorsque le transformateur est disposé de cette manière, le dispositif de mesure ne nécessite pas de blindage supplémentaire.

D'autres particularités et avantages de l'invention résulteront de la description faite ci-après de modes de réalisation non limitatifs au regard des dessins annexés pour lesquels :
- Les figures 1 à 3 représentent trois configurations possibles du dispositif de mesure ;
- La figure 4 montre l'association du dispositif de mesure selon sa première configuration avec un blindage et un transformateur de courant ;
- La figure 5 illustre l'association du dispositif de mesure selon sa deuxième configuration avec un déclencheur et un transformateur de courant ;
- La figure 6 présente l'association du dispositif de mesure selon sa troisième configuration avec un déclencheur et un transformateur de courant ;
- La figure 7 propose un dispositif de mesure avec une double boucle.

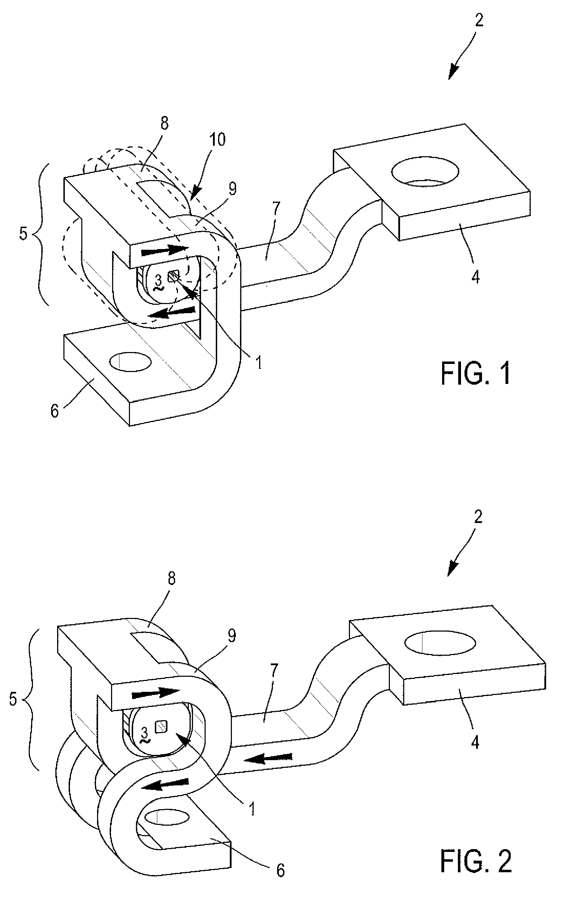

Le dispositif de mesure illustré sur les figures 1 à 3 se compose d'une bobine (1) autour de laquelle s'enroule au moins partiellement un conducteur (2) parcouru par le courant à mesurer.

La bobine (1) est disposée sur une carcasse isolante (3), et correspond à une bobine classique d'allure linéaire, de construction simple.

Le conducteur (2) consiste en une tôle ou plaque métallique comportant :
- une première extrémité (4) consistant en une borne de raccordement ;
- une partie centrale (5) formant une boucle autour de la bobine (1) ;
- une deuxième extrémité (6) consistant également en une borne de raccordement.

Sur la figure 1, la partie centrale (5) du conducteur (2) est constituée d'une branche principale (7) reliée à la première extrémité (4) et passant sous la bobine (1), remontant à l'arrière de la bobine (1), passant au-dessus de la bobine (1), puis se divisant en deux bras (8, 9) passant à l'avant de la bobine (1) et se rejoignant au niveau de la deuxième extrémité (6).

La zone centrale avant (10) de la bobine (1) n'est donc pas couverte par le conducteur (2). Cela n'a pas une grande importance puisque les lignes de champs de la bobine (1), dont certaines sont représentées en traits pointillés, partent des deux extrémités de la bobine (1) et viennent entourer les bras (8, 9) du conducteur (2). Il est aussi tout à fait possible de prolonger la branche principale (7) jusqu'à l'avant de la bobine (1) et la diviser ensuite en deux bras. Il est cependant indispensable que les différents tronçons du conducteur (2) ne se touchent pas pour éviter tout court-circuit.

Les courants circulants autour de la bobine (1) sont représentés par des flèches. Dans le cas de la figure 1, et dans une perspective magnétique, les courants s'annulent logiquement, et rien ne sert de placer une culasse magnétique autour de la boucle.

Sur la figure 2, les bras (8, 9) ont une forme en S et passent sous la bobine (1) avant de se rejoindre au niveau de la deuxième extrémité (6) du conducteur (2). Dans ce cas, le conducteur (2) repasse deux fois sous la bobine (1) : une première fois avec la branche principale (7), et une seconde fois avec les bras (8, 9).

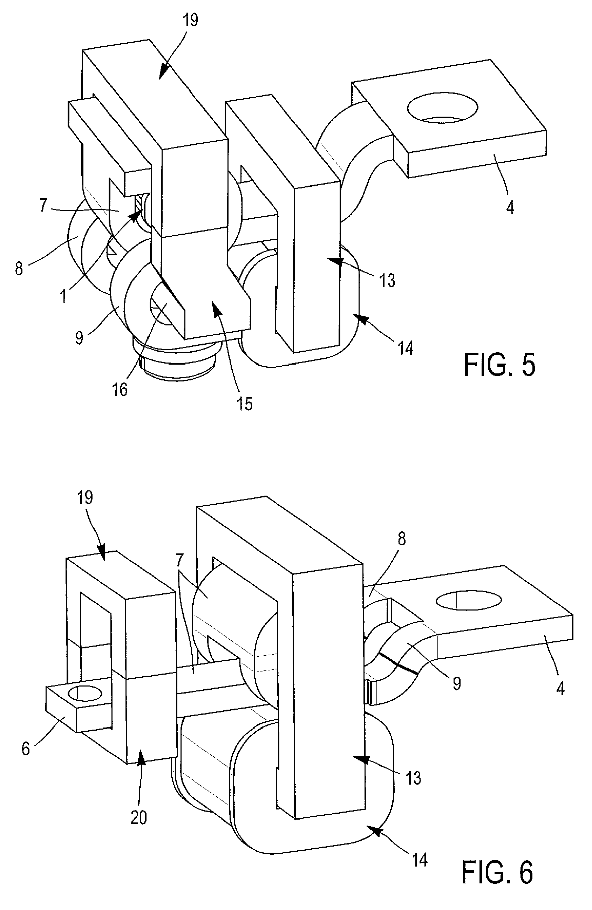

Les courants circulants autour de la bobine (1) ne s'annulent pas, puisqu'il y a deux passages de courant sous la bobine (1) contre un seul passage de courant au-dessus de la bobine (1). La configuration montrée en figure 2 permet donc d'ajouter une fonction déclencheur à ce dispositif de mesure, car une détection d'un courant, et donc d'une surintensité, est possible. Cela sera expliqué plus en détail avec la figure 5.

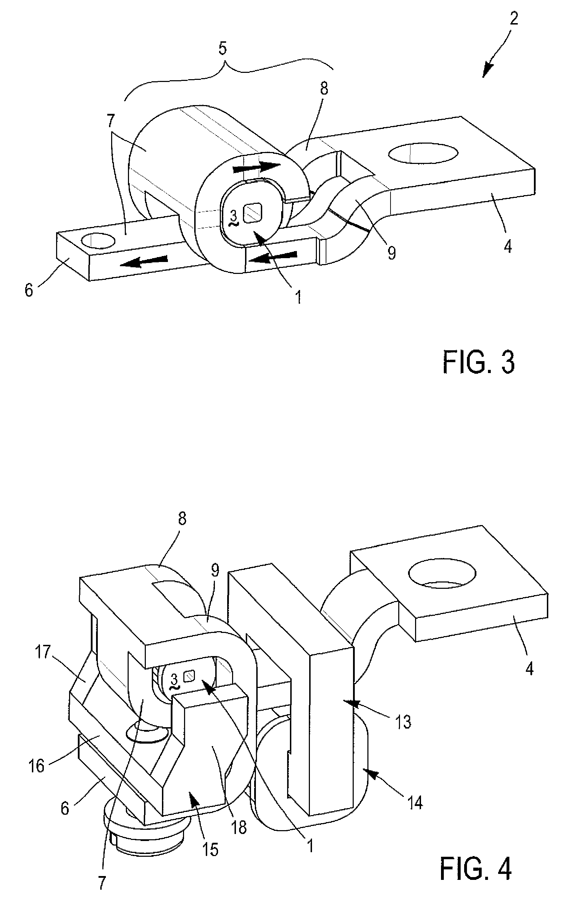

La configuration montrée en figure 3 illustre simplement une inversion entre les bras (8, 9) et la branche principale (7) par rapport aux configurations des figures 1 et 2. Dans ce cas, la partie centrale (5) du conducteur (2) est constituée des deux bras (8, 9) s'étendant de la première extrémité (4) et passant sous la bobine (1) puis je rejoignant à l'arrière de la bobine (1) en une branche principale (7) venant couvrir le dessus, l'avant et le dessous de la bobine (1). Au niveau de l'avant de la bobine (1), la branche principale (7) subit une réduction de sa largeur de manière à ce qu'elle puisse passer entre les bras (8, 9) sous la bobine (1). La branche principale (7) et les bras (8, 9) sont ainsi coplanaires sous la bobine (1).

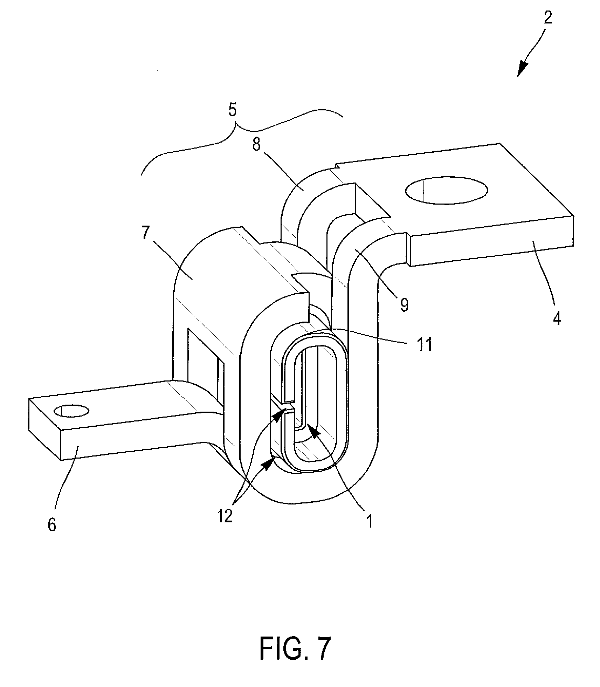

En partant de la configuration proposée en figure 3, le conducteur (2) sur la figure 7 se divise encore avec un bras supplémentaire (11) réalisant une seconde boucle autour de la bobine (1). Un interstice (12), du type entrefer, entre les portions du conducteur (2) réalisant la première boucle et la seconde boucle est conservé afin, d'une part, d'éviter des les mettre en contact et ainsi éviter tout court-circuit, et d'autre part de créer des zones de ventilation pour éviter un échauffement anormal autour de la bobine (1).

La figure 4 reprend la configuration du conducteur (2) de la figure 1. Le dispositif de mesure est cette fois associé à un transformateur de courant comportant :
- un circuit ou noyau magnétique (13) entourant une portion de la branche principale (7) du conducteur (2) ;
- une bobine secondaire (14) entourant une portion du circuit magnétique (13).

Ce transformateur sert à alimenter une électronique de commande non représentée.

Le circuit magnétique (13) du transformateur ayant tendance à attirer les flux magnétique provenant de la bobine (1), donc à dévier les lignes de champs, il est préférable d'ajouter un blindage (15) autour de la partie centrale (5) du conducteur (2) de manière à canaliser et guider les flux magnétiques. Ce blindage (15) est en matériau ferromagnétique, et consiste en un U dont la base (16) est située entre la branche principale (7) et la deuxième extrémité (6) sous la bobine (1), et les deux parties de la fourche (17, 18) sont dirigées respectivement vers les deux extrémités de la bobine (1).

Ce blindage (15) est directement fixé au conducteur (2) par vissage sur la borne (6).

La figure 5 reprend la configuration du conducteur (2) de la figure 2. Le dispositif de mesure est également associé à un transformateur de courant comportant un circuit magnétique (13) et une bobine (14) comme expliqué précédemment.

Il comprend également un blindage (15) dont la base (16) est située cette fois entre les bras (8, 9) et la deuxième extrémité (6) sous la bobine (1).

Puisque dans cette configuration la somme des courants circulant autour de la bobine (1) n'est pas nulle, il est possible d'associer une fonction déclencheur à ce dispositif de mesure. Pour ce faire, le blindage (15) est réutilisé, et associé à une palette mobile (19) en forme de U renversé venant se positionner en face du blindage (15), de manière à former un circuit magnétique avec entrefers autour de la boucle du conducteur (2). Cette fonction déclencheur permet ainsi de provoquer, par exemple via un déclencheur, le déclenchement d'une serrure (non représentée) lorsqu'une surcharge de type court-circuit traverse le conducteur (2).

La figure 6 reprend la configuration du conducteur (2) de la figure 3. Sur cette figure 6, le dispositif de mesure est associé à un transformateur dont le circuit magnétique (13) est cette fois placé autour de la boucle du conducteur (2) entourant la bobine (1). Dans ce cas, le circuit magnétique (13) canalise et guide les flux à la manière du blindage décrit précédemment.

Dans cette configuration, il est possible d'ajouter un système déclencheur autour d'un tronçon du conducteur (2). Ledit système déclencheur comporte classiquement une base fixe (20) ayant la même structure que le blindage (15) précédent, et une palette mobile (19) également telle que décrite auparavant. Il est étalonné mécaniquement pour que la palette (19) ne soit attirée par la base (20) qu'après un certain seuil de courant dans le conducteur (2).

## Revendications

1. Dispositif de mesure de courant comportant au moins une bobine (1), sans noyau ferromagnétique, placée au voisinage d'un conducteur (2) parcouru par le courant à mesurer et entourant au moins partiellement ladite bobine (1), ledit conducteur (2) étant constitué d'une tôle métallique comportant :
- une partie centrale (5) se divisant en plusieurs bras de manière à réaliser une boucle entourant la bobine (1) ;
- une première et une deuxième extrémités (4, 6) consistant en des bornes de raccordement,
**caractérisé en ce que** la partie centrale (5) du conducteur (2) est constituée d'une branche principale (7) relié à l'une (4) des extrémités (4, 6) et entourant au moins la moitié de la bobine (1), qui s'élargit et se divise en deux bras (8, 9) passant de part et d'autre de la branche principale (7) et se rejoignant au niveau de l'autre extrémité (6).

2. Dispositif de mesure de courant selon la revendication précédente, **caractérisé en ce que** la plus grande largeur de la branche principale (7) correspond sensiblement à la longueur de la bobine (1).

3. Dispositif de mesure de courant selon l'une des revendications précédentes, **caractérisé en ce que** les bras (8, 9) et la branche principale (7) sont coplanaires au niveau de la fermeture de la boucle.

4. Dispositif de mesure de courant selon l'une des revendications précédentes, **caractérisé en ce que** lesdits deux bras (8, 9) ont une forme en S, un des arcs inversés du S fermant la boucle entourant la bobine (1) et l'autre se terminant au niveau d'une borne de raccordement d'une extrémité (6).

5. Dispositif de mesure de courant selon l'une des revendications précédentes, **caractérisé en ce que** la partie centrale (5) comporte une dérivation (11) reliée auxdits bras (8, 9) ou à la branche principale (7) et venant entourer la bobine (1) de manière à réaliser une seconde boucle autour de la bobine (1).

6. Dispositif de mesure de courant selon l'une des revendications précédentes, **caractérisé en ce que** les extrémités (4, 6) formant bornes de raccordement sont orientées sensiblement parallèlement l'une à l'autre.

7. Dispositif de mesure de courant selon l'une des revendications précédentes, **caractérisé en ce qu'**il comporte des moyens de guidage du flux magnétique généré par la bobine (1).

8. Dispositif de mesure de courant selon la revendication précédente, **caractérisé en ce que** lesdits moyens de guidage du flux magnétique consistent en au moins un blindage (15) en U entourant une portion de la boucle constituant la partie centrale (5) du conducteur (2).

9. Dispositif de mesure de courant selon la revendication précédente, **caractérisé en ce que** la base (16) du blindage (15) est disposée parallèlement à et entre d'une part une portion de la partie centrale (5) du conducteur(2) entourant la bobine (1) et d'autre part une extrémité (6) du conducteur (2) située en regard, les deux branches (17, 18) du U étant dirigées respectivement en direction des deux extrémités de la bobine (1).

10. Dispositif de mesure de courant selon l'une des revendications 8 et 9, **caractérisé en ce que** ledit blindage (15) est en matériau ferromagnétique.

11. Dispositif de mesure de courant selon l'une des revendications 8 à 10, **caractérisé en ce que** le blindage (15) en U peut être associé à une palette mobile (19) de manière à former un circuit magnétique autour de la boucle du conducteur (2).

12. Dispositif de mesure de courant selon l'une des revendications précédentes, **caractérisé en ce qu'**il peut être associé à un transformateur de courant à noyau magnétique (13) disposé autour d'un tronçon du conducteur (2) et servant à alimenter une électronique de commande via un bobinage secondaire (14).

13. Dispositif de mesure de courant selon la revendication précédente, **caractérisé en ce que** le noyau magnétique (13) dudit transformateur peut être disposé autour de la partie centrale (5) en boucle du conducteur (2).

14. Dispositif de mesure de courant selon l'une des revendications précédentes, **caractérisé en ce qu'**il comprend une seule bobine (1) disposée sur une carcasse (3) isolante.

15. Dispositif de mesure de courant selon l'une des revendications précédentes, **caractérisé en ce que** la bobine (1) comporte un nombre de spires de fil invariable par unité de longueur.

## Patentansprüche

1. Vorrichtung zur Messung eines Stroms, welche mindestens eine Spule (1) ohne ferromagnetischen Kern umfasst, die benachbart zu einem Leiter (2) platziert ist, durch den der zu messende Strom fließt und der mindestens teilweise die Spule (1) umgibt, wobei der Leiter (2) aus einem Metallblech besteht, umfassend:
- einen zentralen Abschnitt (5), der sich in mehrere Arme derart teilt, dass eine die Spule (1) umgebende Schleife gebildet wird,
- ein erstes und ein zweites Ende (4, 6), die aus Anschlussklemmen bestehen,
**dadurch gekennzeichnet, dass**
der zentrale Abschnitt (5) des Leiters (2) aus einem Hauptzweig (7) besteht, der mit einem (4) der Enden (4, 6) verbunden ist und mindestens die Hälfte der Spule (1) umgibt, und der sich verbreitert und in zwei Arme (8, 9) teilt, die sich auf beiden Seiten des Hauptzweigs (7) erstrecken und auf der Höhe des anderen Endes (6) zusammenlaufen.

2. Vorrichtung zur Messung eines Stroms nach dem vorhergehenden Anspruch,
**dadurch gekennzeichnet, dass**
die größte Breite des Hauptzweigs (7) im Wesentlichen der Länge der Spule (1) entspricht.

3. Vorrichtung zur Messung eines Stroms nach einem der vorhergehenden Ansprüche,
**dadurch gekennzeichnet, dass**
die Arme (8, 9) und der Hauptzweig (7) auf der Höhe, auf welcher die Schleife sich schließt, koplanar sind.

4. Vorrichtung zur Messung eines Stroms nach einem der vorhergehenden Ansprüche,
**dadurch gekennzeichnet, dass**
die beiden Arme (8, 9) die Form eines S aufweisen, wobei einer der umgekehrten Bögen des S die Schleife bildet, welche die Spule (1) umgibt, und der andere auf der Höhe einer Anschlussklemme eines Endes (6) endet.

5. Vorrichtung zur Messung eines Stroms nach einem der vorhergehenden Ansprüche,
**dadurch gekennzeichnet, dass**
der zentrale Abschnitt (5) eine Abzweigung (11) umfasst, die mit den Armen (8, 9) oder mit dem Hauptzweig (7) verbunden ist und die Spule (1) derart umgibt, dass eine zweite Schleife um die Spule (1) gebildet wird.

6. Vorrichtung zur Messung eines Stroms nach einem der vorhergehenden Ansprüche,
**dadurch gekennzeichnet, dass**
die Enden (4, 6), die Anschlussklemmen bilden, im Wesentlichen parallel zueinander ausgerichtet sind.

7. Vorrichtung zur Messung eines Stroms nach einem der vorhergehenden Ansprüche,
**gekennzeichnet durch**
Mittel zum Führen des von der Spule (1) generierten Magnetflusses.

8. Vorrichtung zur Messung eines Stroms nach dem vorhergehenden Anspruch,
**dadurch gekennzeichnet, dass**
die Mittel zum Führen des Magnetflusses mindestens aus einer Abschirmung (15) in U-Form bestehen, welche einen Abschnitt der Schleife umgibt, die den zentralen Abschnitt (5) des Leiters (2) bildet.

9. Vorrichtung zur Messung eines Stroms nach dem vorhergehenden Anspruch,
**dadurch gekennzeichnet, dass**
die Basis (16) der Abschirmung (15) parallel zu und zwischen einerseits einem Teil des zentralen Abschnitts (5) des Leiters (2), der die Spule (1) umgibt, und andererseits einem Ende (6) des Leiters (2), das gegenüber liegt, angeordnet ist, wobei die beiden Schenkel (17, 18) des U jeweils in die Richtung der beiden Enden der Spule (1) gerichtet sind.

10. Vorrichtung zur Messung eines Stroms nach einem der Ansprüche 8 und 9,
**dadurch gekennzeichnet, dass**
die Abschirmung (15) aus einem ferromagnetischen Material besteht.

11. Vorrichtung zur Messung eines Stroms nach einem der Ansprüche 8 bis 10,
**dadurch gekennzeichnet, dass**
die Abschirmung (15) in U-Form einer beweglichen Palette (19) derart zugeordnet sein kann, dass eine Magnetschaltung um die Schleife des Leiters (2) gebildet wird.

12. Vorrichtung zur Messung eines Stroms nach einem der vorhergehenden Ansprüche,
**dadurch gekennzeichnet, dass**
diese einem Stromtransformator mit einem Magnetkern (13) zugeordnet sein kann, der um einen Abschnitt des Leiters (2) angeordnet ist und zur Versorgung einer Steuerelektronik über eine sekundäre Wicklung (14) dient.

13. Vorrichtung zur Messung eines Stroms nach dem vorhergehenden Anspruch,
**dadurch gekennzeichnet, dass**
der Magnetkern (13) des Transformators um den schleifenförmigen zentralen Abschnitt (5) des Leiters (2) angeordnet sein kann.

14. Vorrichtung zur Messung eines Stroms nach einem der vorhergehenden Ansprüche,
**dadurch gekennzeichnet, dass**
diese eine einzige Spule (1) umfasst, die in einem Isoliergehäuse (3) angeordnet ist.

15. Vorrichtung zur Messung eines Stroms nach einem der vorhergehenden Ansprüche,
**dadurch gekennzeichnet, dass**
die Spule (1) eine invariable Anzahl von Drahtwindungen pro Längeneinheit umfasst.

## Claims

1. Device for measuring current comprising at least one coil (1), without a ferromagnetic core, placed in the proximity of a conductor (2) through which the current to be measured runs and which surrounds said coil (1) at least partially, said conductor (2) being made from a metal sheet comprising:
- a central part (5) dividing itself into a plurality of arms which form a loop surrounding the coil (1);
- a first and a second end (4, 6) consisting of connection terminals, **characterised in that** the central part (5) of the conductor (2) is formed by a main branch (7) connected to one (4) of the ends (4, 6) and surrounding at least half of the coil (1), which branch widens and divides itself into two arms (8, 9) which pass on either side of the main branch (7) and join together again at the other end (6).

2. Device for measuring current according to the preceding claim, **characterised in that** the widest part of the main branch (7) corresponds substantially to the length of the coil (1).

3. Device for measuring current according to any one of the preceding claims, **characterised in that** the arms (8, 9) and the main branch (7) are in the same plane at the point of closure of the loop.

4. Device for measuring current according to any one of the preceding claims, **characterised in that** said two arms (8, 9) are in the form of an S, wherein one of the inverse arcs of the S closes the loop surrounding the coil (1) and the other ends at the point of a connection terminal at one end (6).

5. Device for measuring current according to any one of the preceding claims, **characterised in that** the central part (5) comprises a derivation (11) connected to said arms (8, 9) or to the main branch (7) and surrounding the coil (1) to form a second loop around the coil (1).

6. Device for measuring current according to any one of the preceding claims, **characterised in that** the ends (4, 6) forming connecting terminals are oriented substantially parallel to one another.

7. Device for measuring current according to any one of the preceding claims, **characterised in that** it comprises means for guiding the magnetic flux generated by the coil (1).

8. Device for measuring current according to the preceding claim, **characterised in that** said means for guiding the magnetic flux consist of at least one shield (15) in a U-shape surrounding a portion of the loop forming the central part (5) of the conductor (2).

9. Device for measuring current according to the preceding claim, **characterised in that** the base (16) of the shield (15) is arranged parallel to and between on the one hand a portion of the central part (5) of the conductor (2) surrounding the coil (1) and on the other hand an end (6) of the conductor (2) located opposite, the two branches (17, 18) of the U being directed respectively in the direction of the two ends of the coil (1).

10. Device for measuring current according to any one of claims 8 and 9, **characterised in that** said shield (15) is made from ferromagnetic material.

11. Device for measuring current according to any one of claims 8 to 10, **characterised in that** the U-shaped shield (15) can be connected to a movable vane (19) so as to form a magnetic circuit around the loop of the conductor (2).

12. Device for measuring current according to any one of the preceding claims, **characterised in that** it can be connected to a current transformer having a magnetic core (13) being arranged around a section of the conductor (2) and being used to supply a control electronics via a secondary winding (14).

13. Device for measuring current according to the preceding claim, **characterised in that** the magnetic core (13) of said transformer can be arranged around the central part (5) of the conductor (2) arranged in a loop.

14. Device for measuring current according to any one of the preceding claims, **characterised in that** it comprises a single coil (1) arranged on an insulating body (3).

15. Device for measuring current according to any one of the preceding claims, **characterised in that** the coil (1) comprises an unvarying number of wire turns per unit of length.
